# EUROPEAN PATENT APPLICATION

(11) **EP 4 604 504 A1**
(43) Date of publication of application: **20.08.2025**
(21) Application number: 24760570.2
(22) Date of filing: 21.02.2024
(51) Int. Cl.: H04M 1/02, B23K 26/21, B23K 20/10, H05K 1/11, H05K 3/34

(54) **HOUSING INCLUDING CONDUCTIVE PART, AND ELECTRONIC DEVICE INCLUDING SAME**

(30) Priority: 21.02.2023 KR 20230023178; 08.05.2023 KR 20230059400
(71) Applicant: Samsung Electronics Co., Ltd., Suwon-si, Gyeonggi-do 16677 (KR)
(72) Inventor: OH, Munhyun, Suwon-si, Gyeonggi-do 16677 (KR)
(74) Representative: Appleyard Lees IP LLP
(86) International application number: PCT/KR2024/002267
(87) International publication number: WO 2024/177381

(57) **Abstract**

According to an embodiment, an electronic device may be provided which includes: a housing including a conductive part; a substrate arranged inside the housing; and a metal pad electrically connecting the substrate with the conductive part, wherein at least a portion of one surface of the metal pad faces the substrate and is soldered to the substrate, and at least a portion of the other surface thereof faces the conductive part and is fixed to the conductive part through laser or ultrasonic welding.

## Description

### [Technical Field]

Various embodiments of the disclosure relate to a housing including a conductive portion and an electronic device including the same.

### [Background Art]

Electronic devices armored with brand-new functionalities are quickly developing, and with them flourishing, portable terminals or such electronic devices are becoming important part of people's everyday life. The advance in mobile technology is leading to increasing demand for more compact and lightweight portable terminals, e.g., smartphones, with improved user portability and convenience along with the need for integrating the parts in a smaller space for higher performance.

Further, to provide a service of stable quality in a commercialized wireless communication network environment, the antenna device of the electronic device should meet wide beam coverage and a high gain. Recently, communication such as mobile communication (e.g., 2G/3G/4G/UMTS/LTE), Bluetooth, Wi-Fi, NFC, GPS, and UWB in low/medium/high frequency bands of several GHz or less supporting multiple bands, as well as millimeter wave communication having a frequency band of several tens of GHz or more (e.g., a high-band frequency of 28 GHz or more), has been used to meet demand for soaring data traffic.

To apply various mobile communication technologies to an electronic device, the electronic device may have various antenna modules and/or antenna radiators. At least a portion of the housing of the electronic device may be formed of a conductive material (e.g., metal), and this portion (hereinafter, referred to as a 'metal frame') may be utilized as an antenna radiator (hereinafter, referred to as a 'metal antenna'). To exhibit the antenna performance of the electronic device in utilizing the metal frame as an antenna, various factors, such as interference between antennas disposed in the electronic device and integration and a proper distribution of supported bands, should be considered.

At least one connecting member (or coupling member) may be provided for connecting the metal frame with a printed circuit board which is disposed in an inner space of the housing to feed or ground the metal frame and on which at least one component (e.g., a communication module) is disposed. As an example of the connecting member, a C-clip may be applied which is disposed between the metal frame and one surface of the printed circuit board while being pressed by some degree to electrically connect a component on the printed circuit board with the metal frame. Further, when a C-clip is used to connect the metal frame to the printed circuit board, a flange may be provided which protrudes and extends from the metal frame to the inner space of the housing.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

According to an example embodiment, there may be provided an electronic device comprising: a housing including a conductive portion, a board disposed inside the housing, and a metal pad electrically connecting the board and the conductive portion. The metal pad may include a first surface at least partially facing the board and fixed to the board by soldering and a second surface at least partially facing the conductive portion and fixed to the conductive portion by laser welding or ultrasonic welding.

According to an example embodiment, an electronic device may comprise: a front plate, a rear plate facing away from the front plate, and a side bezel structure surrounding a space between the front plate and the rear plate. The side bezel structure may include a conductive portion disposed adjacent to an inner space of the housing. The electronic device may comprise: a board disposed inner space of the housing and including a recess, and a metal pad electrically connecting the printed circuit board and the conductive portion. The metal pad may include a first surface at least partially facing the printed circuit board and fixed to the board by soldering and a second surface at least partially facing the conductive portion and fixed to the conductive portion by laser welding or ultrasonic welding.

A method of operating an electronic device is provided. According to an example embodiment, the method may comprise attaching a metal pad to a first surface of a board. According to an embodiment, the method may comprise positioning the metal pad on a surface of a terminal portion. According to an example embodiment, the method may comprise welding the metal pad to the terminal portion using a laser beam or an ultrasonic wave provided from a direction parallel to a direction which the first surface faces.

### [Brief Description of Drawings]

The foregoing and other aspects, features, and/or advantages of an embodiment of the present disclosure will be more apparent from the following detailed description, taken in conjunction with the accompanying drawings, in which:
FIG. 1 is a block diagram illustrating an electronic device in a network environment according to an embodiment;
FIG. 2 is a front perspective view illustrating an electronic device according to an embodiment;
FIG. 3 is a rear perspective view illustrating an electronic device according to an embodiment;
FIG. 4 includes a partial perspective view and diagram illustrating an inner surface of an electronic device according to an embodiment;
FIG. 5 is a cross-sectional view illustrating a side surface of an electronic device according to an embodiment;
FIG. 6 is a diagram illustrating an enlarged view of a side bezel structure and a flange according to an embodiment;
FIG. 7A is a diagram illustrating a side view of a metal-board connecting structure of an electronic device according to an embodiment (comparative embodiment);
FIG. 7B is a diagram illustrating a side view of a metal-board connecting structure of an electronic device according to an embodiment (comparative embodiment);
FIG. 8 is a diagram illustrating a front view of a terminal portion of a metal-board connecting structure according to an embodiment (comparative embodiment);
FIG. 9 is a diagram illustrating a side view of a metal-board connecting structure of an electronic device according to an embodiment;
FIG. 10 is a diagram illustrating a front view of a terminal portion of a metal-board connecting structure according to an embodiment;
FIG. 11A is a diagram illustrating a rear view of a board of a metal-board connecting structure according to an embodiment;
FIG. 11B is a diagram illustrating a rear view of a board of a metal-board connecting structure according to an embodiment;
FIG. 11C is a diagram illustrating a rear view of a board of a metal-board connecting structure according to an embodiment;
FIG. 11D is a diagram illustrating a rear view of a board of a metal-board connecting structure according to various embodiments; and
FIG. 12 is a flowchart illustrating an example method for manufacturing an electronic device according to an embodiment.

Throughout the drawings, like reference numerals may be assigned to like parts, components, and/or structures.

### [Mode for the Invention]

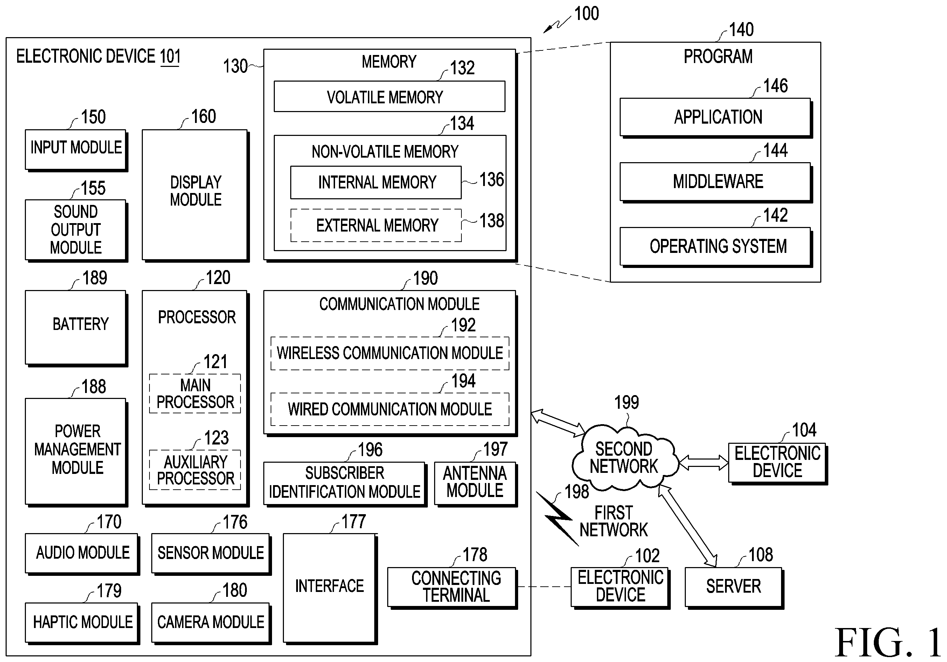

FIG. 1 is a block diagram illustrating an example electronic device 101 in a network environment 100 according to an embodiment.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

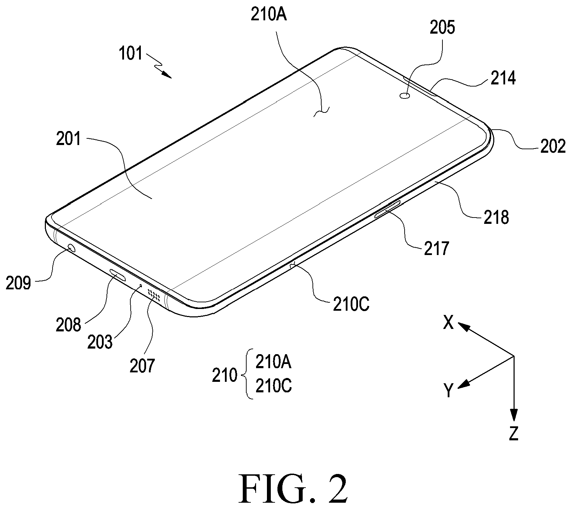

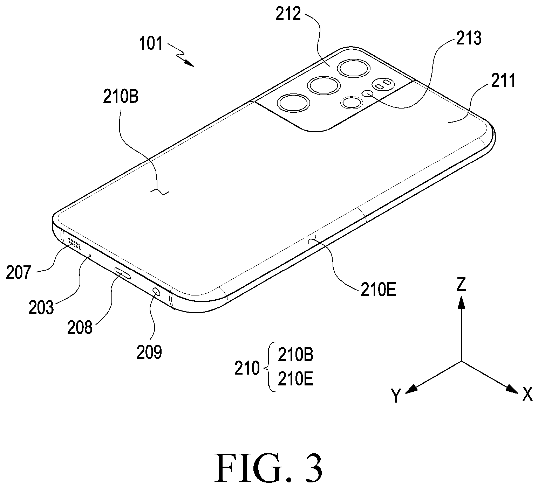

FIG. 2 is a front perspective view illustrating an example electronic device according to an embodiment. FIG. 3 is a rear perspective view illustrating an example electronic device according to an embodiment.

In FIGS. 2 and 3 and subsequent figures, a spatial coordinate system including an X axis, a Y axis substantially perpendicular to the X axis, and a Z axis substantially perpendicular to the X axis and the Y axis may be illustrated. According to an embodiment, in the spatial coordinate system, the X axis may correspond to a width direction of the electronic device 101, the Y axis may correspond to a length direction of the electronic device 101, and the Z axis may correspond to a height direction of the electronic device 101. Hereinafter, in describing various example embodiments, the Z axis in the spatial coordinate system may correspond to a 'height direction (or hereinafter referred to as a 'second direction') mentioned in the following description.

Referring to FIGS. 2 and 3, according to an embodiment, an electronic device 101 may include a housing 210 with a front surface 210A, a rear surface 210B, and a side surface 210C surrounding a space between the front surface 210A and the rear surface 210B. In an embodiment (not shown), the housing 210 may denote a structure forming part of the front surface 210A, the rear surface 210B, and the side surface 210C of FIG. 2. According to an embodiment, at least part of the front surface 210A may have a substantially transparent front plate 202 (e.g., a glass plate or polymer plate including various coating layers). The rear surface 210B may be formed by a rear plate 211. The rear plate 211 may be formed of, e.g., glass, ceramic, polymer, metal (e.g., aluminum, stainless steel (STS), zinc, titanium, and/or magnesium), or a combination of at least two thereof. The side surface 210C may be formed by a side bezel structure (or a "side member") 218 that couples to the front plate 202 and the rear plate 211 and includes a metal and/or polymer. According to an embodiment, the rear plate 211 and the side bezel plate 218 may be integrally formed together and include the same material (e.g., glass, metal, such as aluminum, or ceramic).

**In** the embodiment illustrated, the front plate 202 may include two first edge areas 210D, which seamlessly and bendingly extend from the first surface 210A to the rear plate 211, on both the long edges of the front plate 202. **In** the embodiment (refer to FIG. 3) illustrated, the rear plate 211 may include two second edge areas 210E, which seamlessly and bendingly extend from the rear surface 210B to the front plate 202, on both the long edges. **In** an embodiment, the front plate 202 (or the rear plate 211) may include only one of the first edge areas 210D (or the second edge areas 210E). **In** an embodiment, the first edge areas 210D or the second edge areas 210E may partially be excluded. According to an embodiment, at side view of the electronic device 101, the side bezel structure 218 may have a first thickness (or width) for sides that do not have the first edge areas 210D or the second edge areas 210E and a second thickness, which is smaller than the first thickness, for sides that have the first edge areas 210D or the second edge areas 210E.

According to an embodiment, the electronic device 101 may include at least one of a display 201, audio modules 203, 207, and 214 (e.g., the audio module 170 of FIG. 1), a sensor module (e.g., the sensor module of FIG. 1). 176), camera modules 205 and 212 (e.g., the camera module 180 of FIG. 1), a key input device 217 (e.g., the input module 150 of FIG. 1), and connector holes 208 and 209 (e.g., the connection terminal 178 of FIG. 1). In an embodiment, the electronic device 101 may exclude at least one (e.g., the connector hole 209) of the components or may add other components.

According to an embodiment, the display 201 may be visually revealed through, e.g., a majority portion of the front plate 202. In an embodiment, at least a portion of the display 201 may be visible through the front plate 202 forming the front surface 210A and the first edge areas 210D. In an embodiment, the edge of the display 201 may be formed to be substantially the same in shape as an adjacent outer edge of the front plate 202. In an embodiment (not shown), the interval between the outer edge of the display 201 and the outer edge of the front plate 202 may remain substantially even to give a larger area of exposure the display 201.

According to an embodiment, the surface (or the front plate 202) of the housing 210 may include a screen display area formed as the display 201 is visually exposed. For example, the screen display area may include the front surface 210A and first edge areas 210D.

In an embodiment, a recess or opening may be formed in a portion of the screen display area (e.g., the front surface 210A or the first edge area 210D) of the display 201, and at least one or more of the audio module 214, sensor module (not shown), light emitting device (not shown), and camera module 205 may be aligned with the recess or opening. In an embodiment (not shown), at least one or more of the audio module 214, sensor module (not shown), camera module 205, fingerprint sensor (not shown), and light emitting device (not shown) may be included on the rear surface of the screen display area of the display 201.

In an embodiment (not shown), the display 201 may be disposed to be coupled with, or adjacent, a touch detecting circuit, a pressure sensor capable of measuring the strength (pressure) of touches, and/or a digitizer for detecting a magnetic field-type stylus pen.

In an embodiment, at least part of the key input device 217 may be disposed in the first edge areas 210D and/or the second edge areas 210E.

According to an embodiment, the audio modules 203, 207, and 214 may include, e.g., a microphone hole 203 and speaker holes 207 and 214. A microphone for acquiring external sounds may be disposed in the microphone hole 203. In an embodiment, a plurality of microphones may be disposed to detect the direction of the sound. The speaker holes 207 and 214 may include an external speaker hole 207 and a phone receiver hole 214. According to an embodiment, the speaker holes 207 and 214 and the microphone hole 203 may be implemented as a single hole, or speakers may be included without the speaker holes 207 and 214 (e.g., piezo speakers). The audio modules 203, 207, and 214 are not limited to the above-described structure. Depending on the structure of the electronic device 101, various design changes may be made-e.g., only some of the audio modules may be disposed, or a new audio module may be added.

According to an embodiment, the sensor modules (not shown) may generate an electrical signal or data value corresponding to an internal operating state or external environmental state of the electronic device 101. The sensor modules (not shown) may include a first sensor module (not shown) (e.g., a proximity sensor) and/or a second sensor module (not shown) (e.g., a fingerprint sensor) disposed on the front surface 210A of the housing 210 and/or a third sensor module (not shown) (e.g., an HRM sensor) and/or a fourth sensor module (not shown) (e.g., a fingerprint sensor) disposed on the rear surface 210B of the housing 210. In an embodiment (not shown), the fingerprint sensor may be disposed on the rear surface 210B as well as on the front surface 210A (e.g., the display 201) of the housing 210. The electronic device 101 may further include sensor modules not shown, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor (not shown). The sensor module (not shown) is not limited to the above-described structure. Depending on the structure of the electronic device 101, various design changes may be made--e.g., only some of the sensor modules may be disposed, or a new sensor module may be added.

According to an embodiment, the camera modules 205, 212, and 213 may include a first camera module 205 disposed on the first surface 210A of the electronic device 101, and a rear camera device 212 and/or a flash 213 disposed on the rear surface 210B. The camera modules 205 and 212 may include one or more lenses, an image sensor, and/or an image signal processor. The flash 213 may include, e.g., a light emitting diode (LED) or a xenon lamp. In an embodiment, two or more lenses (an infrared (IR) camera, a wide-angle lens, and a telescopic lens) and image sensors may be disposed on one surface of the electronic device 101. The camera modules 205, 212, and 213 are not limited to the above-described structure. Depending on the structure of the electronic device 101, various design changes may be made--e.g., only some of the camera modules may be disposed, or a new camera module may be added.

According to an embodiment, the electronic device 101 may include a plurality of camera modules (e.g., a dual camera or triple camera) having different attributes (e.g., angle of view) or functions. For example, a plurality of camera modules 205 and 212 including lenses having different angles of view may be configured, and the electronic device 101 may control to change the angle of view of the camera modules 205 and 212 performed by the electronic device 101 based on the user's selection. At least one of the plurality of camera modules 205 and 212 may form, for example, a wide-angle camera and at least another of the plurality of camera modules may form a telephoto camera. Similarly, at least one of the plurality of camera modules 205 and 212 may be a front camera and at least another of the plurality of camera modules may be a rear camera. Further, the plurality of camera modules 205 and 212 may include at least one of a wide-angle camera, a telephoto camera, and an infrared (IR) camera (e.g., a time of flight (TOF) camera, a structured light camera). According to an embodiment, the IR camera may be operated as at least a portion of the sensor module. For example, the TOF camera may be operated as at least a portion of a sensor module (not shown) for detecting the distance to the subject.

According to an embodiment, the key input device 217 may be disposed on the side surface 210C of the housing 210. According to an embodiment, the electronic device 101 may exclude all or some of the above-mentioned key input devices 217 and the excluded key input devices 217 may be implemented in other forms, e.g., as soft keys, on the display 201. In an embodiment, the key input device may include the sensor module (not shown) disposed on the rear surface 210B of the housing 210.

According to an embodiment, the light emitting device may be disposed on, e.g., the front surface 210A of the housing 210. The light emitting device (not shown) may provide, e.g., information about the state of the electronic device 101 in the form of light. According to an embodiment, the light emitting device (not shown) may provide a light source that interacts with, e.g., the front camera module 205. The light emitting device (not shown) may include, e.g., a light emitting diode (LED), an infrared (IR) LED, and/or a xenon lamp.

According to an embodiment, the connector holes 208 and 209 may include, e.g., a first connector hole 208 for receiving a connector (e.g., a universal serial bus (USB) connector) for transmitting or receiving power and/or data to/from an external electronic device and/or a second connector hole (e.g., an earphone jack) 209 for receiving a connector for transmitting or receiving audio signals to/from the external electronic device. The connector holes 208 and 209 are not limited to the above-described structure. Depending on the structure of the electronic device 101, various design changes may be made, such as disposing only some of the connector holes or adding a new connector hole.

According to an embodiment, the camera module 205 and/or the sensor module (not shown) may be disposed to contact the external environment through a designated area of the display 201 and the front plate 202 from the internal space of the electronic device 101. For example, the designated area may be an area in which pixels are not disposed in the display 201. As another example, the designated area may be an area in which pixels are disposed in the display 201. When viewed from above the display 201, at least a portion of the designated area may overlap the camera module 205 and/or the sensor module. As another example, some sensor modules may be arranged to perform their functions without being visually exposed through the front plate 202 from the internal space of the electronic device.

The electronic device 101 disclosed in FIGS. 2 and 3 has a bar-type or plate-type appearance but the disclosure is not limited thereto. For example, the illustrated electronic device may be part of a rollable electronic device or a foldable electronic device. "Rollable electronic device" may refer, for example, to an electronic device at least a portion of which may be wound or rolled or received in a housing (e.g., the housing 210 of FIG. 2) as the display may be bent and deformed. As the display is stretched out or is visually exposed to the outside in a larger area according to the user's need, the rollable electronic device may use an expanded second display area. "Foldable electronic device" may refer, for example, to an electronic device that may be folded in directions to face two different areas of the display or in directions opposite to each other. In general, in the portable state, the foldable electronic device may be folded so that the two different areas of the display face each other and, in an actual use state, the user may unfold the display so that the two different areas form a substantially flat shape. In an embodiment, according to various embodiments of the disclosure, the electronic device 101 may be interpreted as including various electronic devices, such as a laptop computer or a home appliance, as well as a portable electronic device, such as a smart phone.

According to various embodiments of the disclosure, there are provided various embodiments for an electronic device including a housing at least partially including a metal and a connecting structure for connecting the metal to a board (e.g., a printed circuit board (PCB)) to use the whole or part of the housing as an antenna.

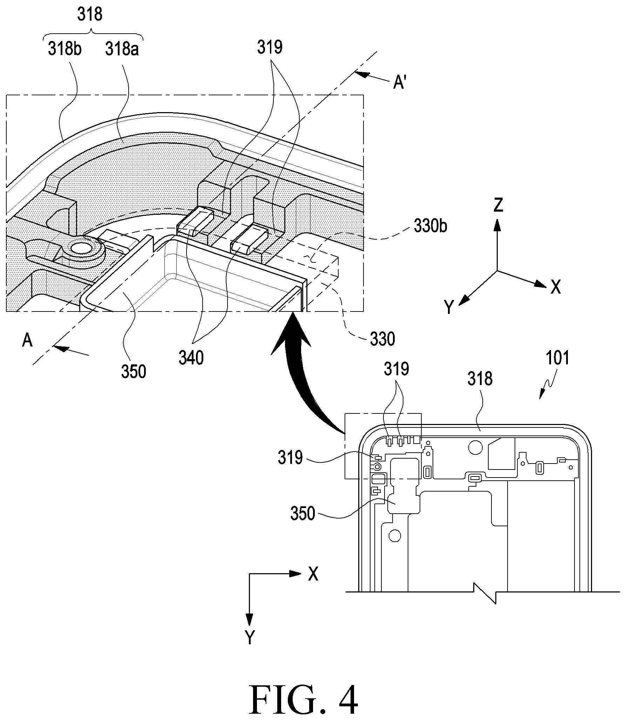

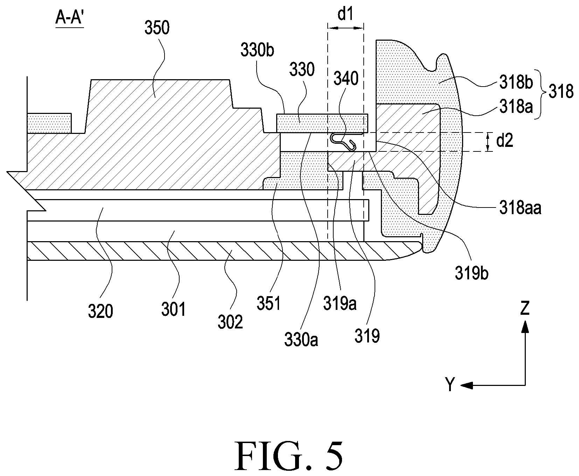

FIG. 4 includes a partial perspective view and a diagram illustrating an inner surface of an electronic device 101 according to an embodiment. FIG. 5 is a cross-sectional view illustrating a side surface of an electronic device 101 according to an embodiment. FIG. 5 illustrate a show a cross section of the electronic device 101 of FIG. 4, taken along direction A-A'.

Referring to FIGS. 4 and 5, an electronic device 101 according to an embodiment may include a display 301 (e.g., the display 201 of FIG. 2), a front plate 302 (e.g., the front plate 202 of FIG. 2), a side bezel structure 318 (e.g., the side bezel structure 218 of FIGS. 2 and 3) (which may be referred to hereinafter as a "side surface 318") surrounding an inner space of a housing, board 320 and/or 330, and a connecting member (e.g., including a conductive connector) 340. According to an embodiment, the electronic device 101 may omit at least one of the components or may add another component. For example, the electronic device may further include a rear plate (e.g., the rear plate 211 of FIG. 3) and/or a supporting member 350 (e.g., a bracket) disposed in the inner space of the housing and connected to the side bezel structure 318 or integrally formed with the side bezel structure 318.

Various electronic components, e.g., a processor (e.g., the processor 120 of FIG. 1), memory (e.g., the memory 130 of FIG. 1), and/or an interface (e.g., the interface 177 of FIG. 1) may be disposed on the board 320 and/or 330. Further, a communication module (e.g., the communication module 190 of FIG. 1) and/or an antenna module (e.g., the antenna module 197 of FIG. 1) may be disposed on the printed circuit board 320 and/or 330. According to various embodiments, the board 320 and/or 330 may be referred as a substrate and/or a printed circuit board(PCB). According to various embodiments, the board 320 and/or 330 (hereinafter 'the printed circuit board 320 and/or 330') include a first printed circuit board 320 disposed on one side of the inner space of the housing and a second printed circuit board 330 disposed at a different position from the first printed circuit board 320. According to an embodiment, the first printed circuit board 320 may be a flexible printed circuit board (FPCB) disposed on the rear surface of the display 301, and the second printed circuit board 330 may be a printed circuit board formed of a rigid material. According to an embodiment, both the first printed circuit board 320 and the second printed circuit board 330 may be flexible printed circuit boards (FPCBs). Alternatively, according to an embodiment, both the first printed circuit board 320 and the second printed circuit board 330 may be printed circuit boards formed of a rigid material. According to an embodiment, the second printed circuit board 330 may be a sub printed circuit board (PCB), and may be disposed to be spaced apart from a main printed circuit board (PCB) (e.g., the first printed circuit board 320 or a third printed circuit board not illustrated) in the electronic device. As illustrated in FIGS. 4 and 5, two printed circuit boards 320 and 330 are illustrated but, without limitations thereto, one or three or more printed circuit boards may be provided. Further, the arrangement and use of the printed circuit board(s) (the first printed circuit board 320 and the second printed circuit board 330) mentioned in the disclosure are not limited to any specific embodiment.

A communication module (e.g., the communication module 190 of FIG. 1) and/or an antenna module (e.g., the antenna module 197 of FIG. 1) may be disposed on the printed circuit board 320 and/or 330. When a communication module and/or an antenna module is disposed on the printed circuit board 320 and/or 330, the communication module and/or the antenna module may be utilized to support establishment of a direct (e.g., wired) communication channel or a wireless communication channel between the electronic device 101 and an external electronic device (e.g., the electronic device 102, the electronic device 104, or the server 108 of FIG. 1) and communication through the established communication channel, and to exchange signals therebetween.

According to an embodiment, a portion of the housing 210, e.g., at least a portion of the side bezel structure 318, may be formed of a conductive portion 318a (e.g., metal). Various communications such as 2/3/4G communication, Bluetooth, Wi-Fi, and/or ultra-wide band (UWB) as well as short-range communication such as near field communication (NFC), magnetic secure transmission (MST), and wireless charging may be performed by utilizing the conductive portion 318a of the side bezel structure 318 as an antenna radiator.

In order to utilize the conductive portion 318a of the side bezel structure 318 as an antenna, feeding and/or grounding for the side bezel structure 318 may be required. According to an embodiment, the connecting member 340 may be utilized for feeding and/or grounding. For example, the connecting member 340 may be disposed on the second printed circuit board 330, and electronic components disposed on the second printed circuit board 330 may be electrically connected to the side bezel structure 318 (e.g., the conductive portion 318a) through the connecting member 340.

According to an embodiment, the side bezel structure 318 may include a conductive portion 318a (e.g., a metal frame) and a non-conductive portion 318b (e.g., an injection-molded product) at least partially surrounding the conductive portion 318a. The side bezel structure 318 may further include a terminal portion 319 protruding and extending from the conductive portion 318a to the inner space of the housing. According to the embodiment illustrated in FIGS. 4 and 5, in order to utilize a portion (e.g., the side bezel structure 318) of the housing as an antenna, e.g., the terminal portion 319 may be provided as a component for feeding power to the side bezel structure 318. According to an embodiment, in connecting the connecting member 340 to the side bezel structure 318 for feeding, the terminal portion 319 serving as a flange may be used. According to an embodiment, the terminal portion 319 may protrude and extend from the conductive portion 318a of the side bezel structure 318 to the inner space of the housing. According to an embodiment, by electrically connecting the side bezel structure 318 and the board (e.g., the second printed circuit board 330) on which the electronic component is disposed, it is possible to feed power to the side bezel structure 318. For example, by providing the terminal portion 319 protruding and extending to the inner space of the housing, the second printed circuit board 330 and a portion (e.g., the terminal portion 319) of the side bezel structure 318 may be stacked in the upper/lower direction. Further, stable contact between the second printed circuit board 330 and the side bezel structure 318 may be implemented through the portion where the second printed circuit board 330 and a portion (e.g., the terminal portion 319) of the side bezel structure 318 overlap in the upper/lower direction.

According to an embodiment, the second printed circuit board 330 may include a first surface 330a facing in a first direction (e.g., a direction opposite to the Z-axis) and a second surface 330b facing in a second direction (e.g., a direction parallel to the Z-axis). Referring to FIGS. 4 and 5, it is illustrated that the connecting member 340 is disposed between the first surface (e.g., 330a) of the second printed circuit board 330 and the terminal portion 319. For example, referring to FIGS. 4 and 5, the connecting member 340 may include a c-clip having a predetermined width and height and having elasticity. One portion (hereinafter, referred to as a "base") of the c-clip type connecting member 340 may be fixed to another component (e.g., the second printed circuit board 330), and another portion (hereinafter, referred to as a "tip portion") may be pressed when contacting another component (e.g., the terminal portion 319) but, if the pressing is released, the c-clip type connecting member 340 may be restored to its original shape. Metal may be applied (e.g., gold plated) to at least a portion (e.g., the tip portion) of the c-clip type connecting member 340. The terminal portion 319 may have a sufficient width and length to support the connecting member 340. According to an embodiment, the protruding width and length of the terminal portion 319 may be designed considering the length d1 of the connecting member 340 disposed on the first surface 330a of the second printed circuit board 330. Further, the distance between the terminal portion 319 and the second printed circuit board 330 may be designed considering the height d2 of the connecting member 340.

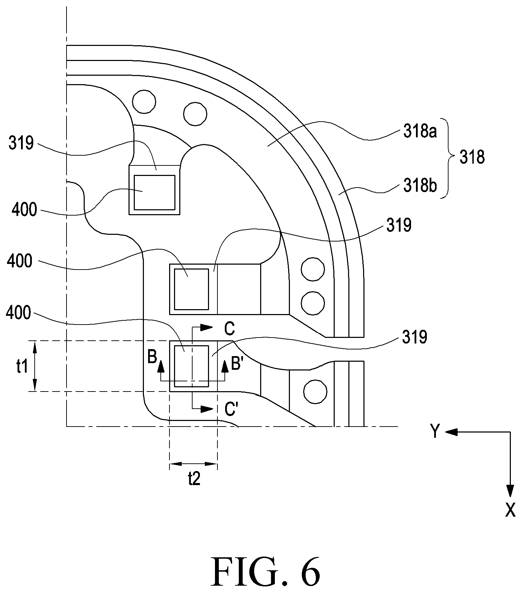

According to an embodiment, the terminal portion 319 may include an end portion 319a and a surface (hereinafter, referred to as a "third surface 319b") facing in a second direction (e.g., a direction parallel to the Z-axis). According to an embodiment, the end portion 319a of the terminal portion 319 may contact another component (e.g., the non-conductive portion 351 of the supporting member 350) as illustrated in FIG. 5, but alternatively (e.g., as illustrated in FIG. 6 below), the end portion 319a may be formed to be spaced apart from other components. According to an embodiment, a portion (e.g., 318aa) of the conductive portion 318a and the third surface 319b of the terminal portion 319a may be exposed to the inner space of the housing. By forming a contact on a portion (e.g., 318aa) of the conductive portion 318a and/or the third surface 319b of the terminal portion 319a, other components (e.g., the printed circuit board 330) disposed inside the electronic device may be electrically connected.

FIG. 6 is a diagram illustrating an enlarged view of a side bezel structure 318 and a terminal portion 319 according to an embodiment. FIG. 6 illustrates the inside of the electronic device 101 illustrated in FIG. 4 when viewed from the front (e.g., in a direction opposite to the Z-axis).

When the side bezel structure 318 including a metal material comes in direct contact with the connecting member 340, galvanic corrosion may occur due to a difference in electro-motive force between metals. Fretting corrosion may occur as the tip portion of the connecting member 340 is slightly repositioned by vibration or impact while the electronic device 101 is in use. When the side bezel structure 318 and the connecting member 340 are formed of different metals (heterogeneous metals), and a high current density is formed in a narrow area, the galvanic corrosion and the fretting corrosion may occur.

To prevent and/or reduce this, a metal pad 400 may be disposed on the terminal portion 319. The metal pad 400 may have a predetermined width t1 and a predetermined length t2 and may be coupled to one surface of the terminal portion 319. According to an embodiment, the metal pad 400 may be attached to one surface of the terminal portion 319 by laser welding or ultrasonic welding. Since the metal pad 400 is provided to contact and/or support the tip portion of the connecting member 340, a predetermined area in contact with the tip portion of the connecting member 340 may be required. Additionally, an area for laser welding may also be required in the metal pad 400. Further, as the size of the metal pad 400 increases, the size of the terminal portion 319 on which the metal pad 400 is disposed may also increase accordingly. As the size of the terminal portion 319 increases, the degree of freedom of design or the performance of the antenna may be reduced in designing the housing as an antenna, and the size and/or performance of electronic components disposed around the terminal portion 319 may also be affected.

Hereinafter, in the disclosure, various embodiments of an electronic device including a housing (e.g., the side bezel structure 318) including a metal and a metal-board (metal-PCB) connecting structure having a freedom of design of electronic device and antenna performance enhanced by downsizing the metal pad 400 and the terminal portion 319 are described.

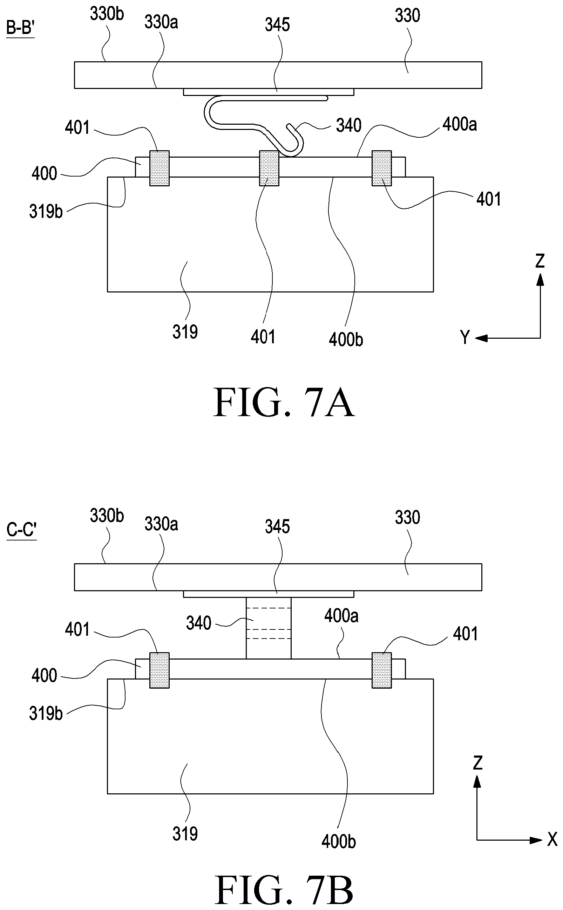

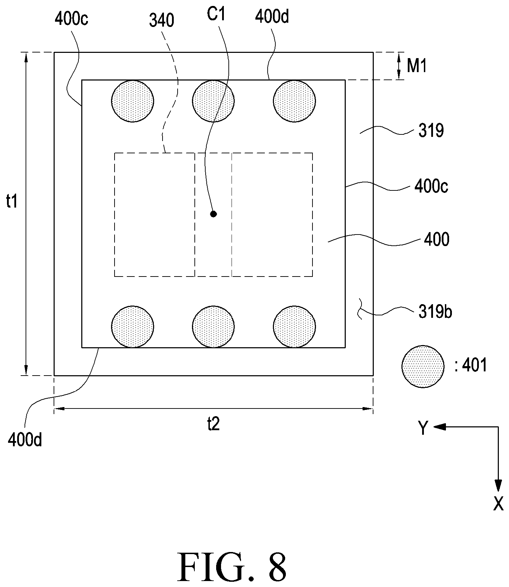

A metal-board connecting structure including a c-clip is described in greater detail below with reference to FIGS. 7A, 7B, and 8.

FIG. 7A is a diagram illustrating a side view of a metal-board connecting structure of an electronic device 101 according to an embodiment (a comparative embodiment). FIG. 7B is a diagram illustrating a side view of a metal-board connecting structure of an electronic device 101 according to an embodiment (a comparative embodiment). FIG. 8 is a diagram illustrating a front view of a metal-board connecting structure of an electronic device 101 according to an embodiment (a comparative embodiment). FIG. 7A may be a side view illustrating a state in which the connecting member 340 contacts the metal pad 400, as viewed along the virtual line B-B' of FIG. 6. FIG. 7B may be a side view illustrating a state in which the connecting member 340 contacts the metal pad 400, as viewed along the virtual line C-C' of FIG. 6. FIG. 8 may illustrate a metal pad and a terminal portion viewed from above (e.g., viewed in a direction opposite to the Z-axis) in the metal-board connecting structure.

In the embodiments of FIGS. 7A, 7B, and 8, the board (PCB) 330 in the metal-board (PCB) connecting structure may be, e.g., a flexible printed circuit board (FPCB). Further, in the embodiments of FIGS. 7A, 7B, and 8, the board 330 may be the second printed circuit board 330 described with reference to FIGS. 4 to 6. Further, in the embodiments of FIGS. 7A, 7B, and 8, the housing may correspond to the side bezel structure 318 described with reference to FIGS. 4 to 6. A terminal portion 319 extending from the side bezel structure 318 is illustrated in FIGS. 7A, 7B, and 8. The terminal portion 319 may protruded from the side bezel structure 318 to the inner space of the housing.

According to an embodiment, a connecting member 340 (e.g., a c-clip) may be disposed between the board 330 and the terminal portion 319. The connecting member 340 may include a base and a tip portion extending from one surface of the base. Here, the tip portion may be elastically pressed by contacting the terminal portion 319 when the electronic device 101 is assembled, and may be configured to maintain contact with the terminal portion 319 using the elastic repulsive force. The connecting member 340 may transfer an electrical signal provided from an electronic component (e.g., an RF communication module and/or a battery) disposed on the board 330 and/or adjacent to the board to the terminal portion 319. According to an embodiment, the board 330 may include a first surface 330a facing in a first direction (e.g., a direction opposite to the Z-axis) and a second surface 330b facing in a second direction (e.g., a direction parallel to the Z-axis). Referring to FIGS. 7A and 7B, the connecting member 340 may be disposed on the first surface 330a of the board 330. According to an embodiment, the connecting member 340 may be disposed in the form of a surface mounted device (SMD) by soldering using a solder portion 345 formed on the first surface 330a of the board 330.

According to an embodiment, a metal pad 400 may be disposed between the board 330 and the terminal portion 319. One surface 400a (e.g., a surface facing in a direction parallel to the Z-axis) of the metal pad 400 may contact a tip portion of the connecting member 340, and another surface 400b (e.g., a surface facing in a direction opposite to the Z-axis) of the metal pad 400 may face and tightly contact a surface (e.g., the third surface 319b) of the terminal portion 319 facing in the second direction (e.g., a direction parallel to the Z-axis).

According to an embodiment, the metal pad 400 may be disposed on the third surface 319b of the terminal portion 319 and may be fixed to the terminal portion 319 using laser or ultrasonic welding. When laser or ultrasonic welding is performed, high-temperature heat may be generated at a designated position between the metal pad 400 and the terminal portion 319, and the metal pad 400 and the terminal portion 319 may be melted by the high-temperature heat so that elements of the metal pad 400 and the terminal portion 319 and the elements may be mixed with each other. When the elements mixed with each other are hardened, the metal pad 400 and the terminal portion 319 may be firmly fixed to each other at the designated position. A contact (or melting point) 401 connecting the metal pad 400 and the terminal portion 319 may be formed at the designated position where laser or ultrasonic welding is performed. In the embodiments (comparative embodiments) illustrated in FIGS. 7A, 7B, and 8, laser or ultrasonic welding may be performed before the connecting member 340 soldered to the board 330 is brought into contact with the metal pad 400.

Referring to FIGS. 7A, 7B, and 8, an area for disposing the connecting member 340 may be formed, typically in the central portion C1 of the metal pad 400. The contact 401 connecting the metal pad 400 and the terminal portion 319 may be formed at a position considering the area for disposing the connecting member 340, e.g., at an edge of the metal pad 400. Referring to FIG. 8, a plurality of contacts 401 may be disposed at an edge adjacent to any one (e.g., the second side 400d) of the first side 400c facing in the Y-axis and the second side 400d facing in the X-axis of the metal pad 400. Here, the first side 400c facing in the Y-axis and the second side 400d facing in the X-axis may be formed as a long side and a short side, respectively, such that the metal pad 400 has a substantially rectangular shape. Further, the plurality of contacts 401 may be symmetrically formed on the left/right sides with respect to the central portion C1 of the metal pad 400. When the plurality of contacts 401 are not symmetrically formed with respect to the central portion C1 of the metal pad 400, the stability of coupling between the metal pad 400 and the terminal portion 319 may be reduced. According to an embodiment, in the case of the metal-board connecting structure including the connecting member 340 (c-clip), the position and size of the connecting member 340 in contact with the metal pad 400 should be considered in designing the metal pad 400, and the design of the plurality of contacts 401 may be restricted accordingly. For example, the sizes of the first side 400c facing in the Y-axis and the second side 400d facing in the X-axis of the metal pad 400 may be required to be designed to have dimensions corresponding to the position and/or size of the connecting member 340 in contact, and the position and/or number of the plurality of contacts 401. Further, a design in which the board 330 and the metal pad 400 are spaced apart from each other by the height of the connecting member 340 may be required.

Further, the design of the terminal portion 319 may also be restricted due to the design limitations of the metal pad 400. For example, the width t1 and the length t2 of the terminal portion 319 may be required to be designed to have dimensions corresponding to the first side 400c facing in the Y-axis and the second side 400d facing in the X-axis of the metal pad 400. Referring to FIG. 8, the terminal portion 319 may be designed to have a margin length as much as M1 with respect to the metal pad 400 considering, e.g., dimensions and/or position of the connecting member 340, assembly tolerances, tolerances for the contact 401, and other design and/or manufacturing tolerances.

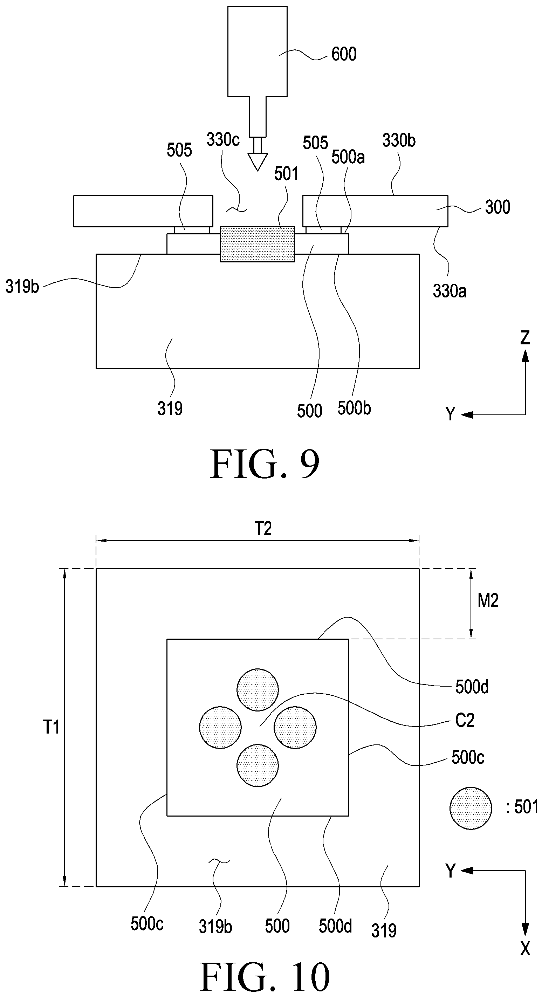

Hereinafter, various example embodiments are described in greater detail with reference to FIGS. 9 and 10.

FIG. 9 is a diagram illustrating a side view of a metal-board connecting structure of an electronic device 101 according to an embodiment. FIG. 10 is a diagram illustrating a front view of a metal-board connecting structure of an electronic device 101 according to an embodiment. FIG. 10 may illustrate a metal pad and a terminal portion viewed from above (e.g., viewed in a direction opposite to the Z-axis) in the metal-board connecting structure.

In the embodiments of FIGS. 9 and 10, the board (PCB) 330 in the metal-board (PCB) connecting structure may be, e.g., a flexible printed circuit board (FPCB). Further, in the embodiments of FIGS. 9 and 10, the board 330 may be the second printed circuit board 330 described with reference to FIGS. 4 to 6. Further, in the embodiments of FIGS. 9 and 10, the housing may correspond to the side bezel structure 318 described with reference to FIGS. 4 to 6. A terminal portion 319 extending from the side bezel structure 318 is illustrated in FIGS. 9 and 10. The terminal portion 319 may protruded from the side bezel structure 318 to the inner space of the housing.

In the embodiments of FIGS. 9 and 10, a metal-board (PCB) connecting structure may be implemented even without the connecting member 340 (e.g., a C-clip) mentioned above in the embodiments for FIGS. 5, 7A, 7B, and 8. The metal-board (PCB) connecting structure according to the embodiments of FIGS. 9 and 10 may transfer an electrical signal provided from an electronic component (e.g., an RF communication module and/or a battery) disposed on the board 330 and/or adjacent to the board to the terminal portion 319 without including a connecting member separately. According to an embodiment, the board 330 may include a first surface 330a facing in a first direction (e.g., a direction opposite to the Z-axis) and a second surface 330b facing in a second direction (e.g., a direction parallel to the Z-axis).

Referring to FIG. 9, a metal pad 500 may be disposed on the terminal portion 319 at a position facing the first surface 330a of the board 330. According to an embodiment, the metal pad 500 may be disposed in the form of a surface mounted device (SMD) by soldering using a solder portion 505 formed on the first surface 330a of the board 330. One surface 500a (e.g., a surface facing in a direction parallel to the Z-axis) of the metal pad 500 may face the first surface 330a of the board 330, and another surface 500b (e.g., a surface facing in a direction opposite to the Z-axis) may face a surface (hereinafter, referred to as a "third surface 319b") of the terminal portion 319 facing in the second direction (e.g., a direction parallel to the Z-axis). According to an embodiment, the metal pad 500 may be soldered to the first surface 330a of the board 330 using the solder portion 505. And then, the metal pad 500 may be fixed to the terminal portion 319 using laser welding or ultrasonic welding. In the embodiments illustrated in FIGS. 9 and 10, the principle in which the metal pad 500 is fixed to the terminal portion 319 using laser welding or ultrasonic welding may be partially similar to the embodiment described above with reference to FIGS. 7A, 7B, and 8.

However, in the embodiments illustrated in FIGS. 9 and 10, the operation of laser welding or ultrasonic welding on the metal pad 500 may be performed after the metal pad 500 is firstly soldered onto the board 330 and is secondly brought into contact with the terminal portion 319. In the embodiments illustrated in FIGS. 9 and 10, the metal pad 500 may be first soldered to the board 330, and then the metal pad 500 soldered to the board 330 may be positioned on the terminal portion 319 by performing laser welding or ultrasonic welding. According to an embodiment, a recess 330c through which laser beams or ultrasonic waves emitted (or radiated) from the laser equipment 600 or ultrasonic equipment may be passed(or transmitted) may be formed in the board 330. By emitting (or radiating) laser beams or ultrasonic waves in a direction parallel to the first direction (e.g., a direction opposite to the Z-axis), a metal-board connecting structure between the metal pad 500 and the terminal portion 319 may be implemented even after the metal pad 500 is first soldered to the board 330.

Further, in the embodiments illustrated in FIGS. 9 and 10, the position where the contact pint (or melting point) 501 connecting the metal pad 500 and the terminal portion 319 is formed may be different from that in the embodiments described above with reference to FIGS. 7A, 7B, and 8. According to the embodiments illustrated in FIGS. 9 and 10, since the metal pad 500 does not need to consider the area in which the connecting member 340 is disposed, a contact point 501 connecting the metal pad 500 and the terminal portion 319 may be formed in the central portion C2 of the metal pad 500. According to an embodiment, the metal pad 500 may include a plurality of contact points 501, and the plurality of contact points 501 may be concentrated and disposed in the central portion C2 of the metal pad 500.

FIG. 10 illustrates that a first side 500c facing in the Y-axis and a second side 500d facing in the X-axis of the metal pad 500 have substantially similar lengths. According to the disclosure, since the connecting member 340 is not provided, the contact point 501 connecting the metal pad 500 and the terminal portion 319 may be provided in the central portion C2 of the metal pad 500, and the metal pad 500 may be designed in a more compact size. Further, as the design of the metal pad 500 becomes more free, the design of the terminal portion 319 may also become more free. For example, the width T1 and the length T2 of the terminal portion 319 may be designed to have dimensions corresponding to the first side 500c facing in the Y-axis and the second side 500d facing in the X-axis of the metal pad 500. Accordingly, referring to FIG. 10, the terminal portion 319 may be designed to have a margin length of M2 greater than the margin length M1 of the embodiment (comparative embodiment) illustrated in FIG. 8 with respect to the metal pad 500 considering other design tolerances.

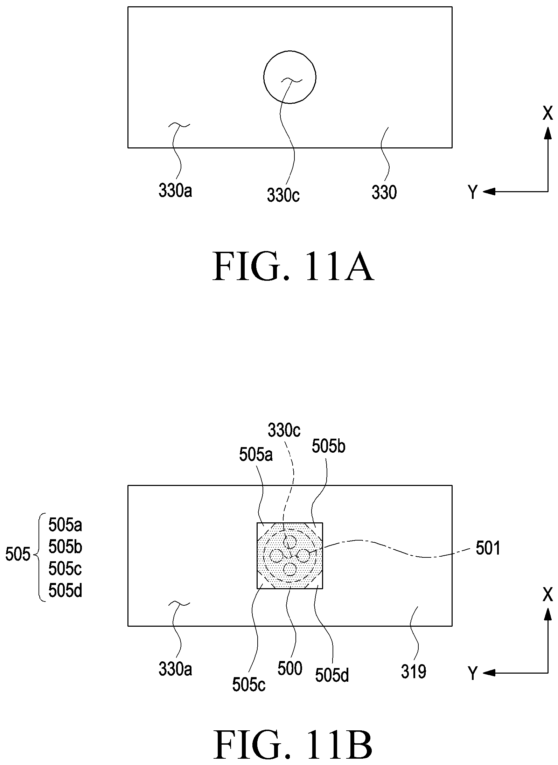

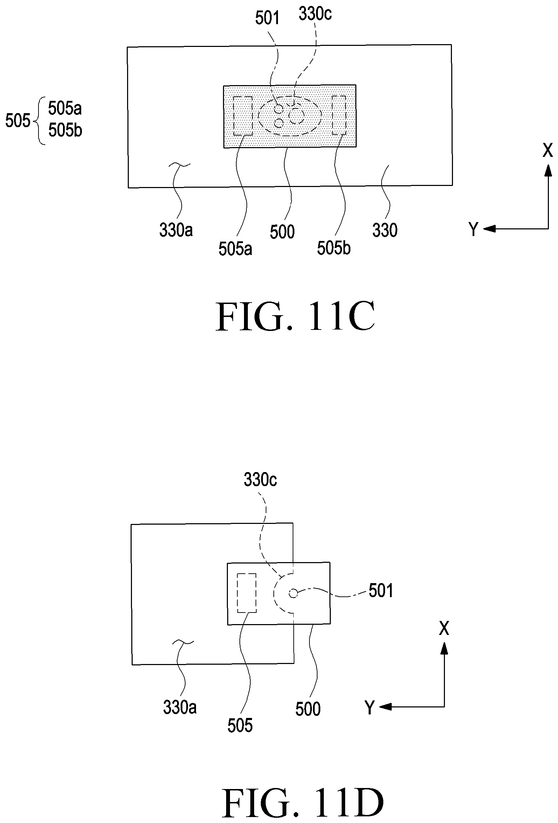

FIG. 11A is a diagram illustrating a rear view of a board of a metal-board connecting structure according to an embodiment. FIG. 11B is a diagram illustrating a rear view of a board of a metal-board connecting structure according to an embodiment. FIG. 11C is a diagram illustrating a rear view of a board of a metal-board connecting structure according to an embodiment. FIG. 11D is a diagram illustrating a rear view of a board of a metal-board connecting structure according to an embodiment.

Referring to FIG. 11A, a recess 330c for laser or ultrasonic welding may be provided in the board 330. The recess 330c may be, e.g., an opening penetrating the first surface 330a and the second surface 330b of the board 330, but is not necessarily limited thereto. The recess 330c may include all various shapes including holes and grooves as long as laser beams or ultrasonic waves may be transmitted therethrough. According to an embodiment, the electronic device 101 may further include a member capable of transmitting laser beams or ultrasonic waves through the recess 330c. The member capable of transmitting the laser beams or ultrasonic waves may include, e.g., a transparent member or a translucent member.

Referring to FIG. 11B, a metal pad 500 may be disposed on the first surface 330a of the board 330. According to an embodiment, the center of the recess 330c formed in the board 330 may be aligned with the center of the metal pad 500. A solder portion 505 may be disposed between the first surface 330a of the board 330 and the metal pad 500. A plurality of solder portions 505 may be disposed, and according to an embodiment, the plurality of solder portions 505 may be radially disposed around a central portion of the recess 330c and/or the metal pad 500. FIG. 11B illustrates an embodiment in which four solder portions 505a, 505b, 505c, and 505d are radially disposed around a central portion of the recess 330c and/or the metal pad 500.

However, the disclosure is not necessarily limited thereto. The number, shape, and/or position of the solder portions 505 may be variously set according to embodiments. Further, the shape and/or position of the recess 330c may also be variously set according to embodiments.

For example, as illustrated in FIG. 11C, the solder portions 505 may include two solder portions 505a and 505b of different shapes. Further, the recess 330c may have an elliptical shape. Further, the contact point 501 may not be formed in the center of the recess 330c. For example, as illustrated in FIG. 11D, only one solder portion 505 may be provided, and the recess 330c may be positioned at an end portion of the board 330. Further, the contact point 501 may also be formed in only one place. Other various embodiments may be applied.

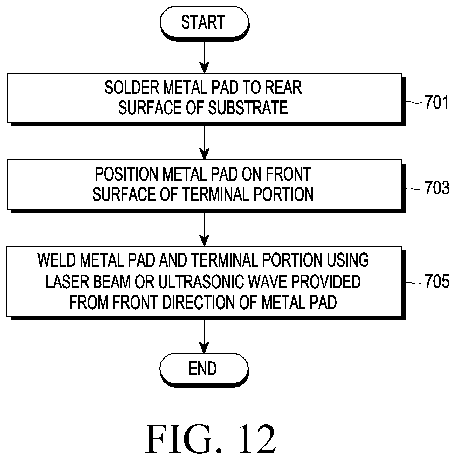

FIG. 12 is a flowchart illustrating an example method for manufacturing an electronic device according to an embodiment.

A method for manufacturing an electronic device according to the disclosure may include a method for manufacturing a metal-board connecting structure according to the examples of FIGS. 9 to 11D.

A method for manufacturing an electronic device may include soldering a metal pad onto a board, positioning the metal pad on a terminal portion, and laser- or ultrasonic-welding the metal pad and the terminal portion. For example, as illustrated in FIG. 12, the method for manufacturing an electronic device may include an operation 701 of soldering the metal pad to a rear surface of the board, an operation 703 of positioning the metal pad on the front surface of the terminal portion, and an operation 705 of welding the metal pad and the terminal portion using a laser beam or ultrasonic wave provided from a front direction of the metal pad.

In connection with operation 701, a metal pad (e.g., the metal pad 400 or 500 of FIGS. 9 to 11D) may be disposed on a rear surface (e.g., the first surface 330a of FIGS. 9 to 11D) of a board (e.g., the board 330 of FIGS. 9 to 11D). The first surface of the board and the metal pad may be soldered and connected to each other.

In connection with operation 703, the metal pad may be positioned on the front surface (e.g., the third surface 319b of FIGS. 9 to 11D) of the terminal portion (e.g., the terminal portion 319 of FIGS. 9 to 11D). In this case, the metal pad may be connected to the board 330 through a solder portion (e.g., the solder portion 505 of FIGS. 9 to 11D). Accordingly, if the metal pad is positioned on the front surface of the terminal portion, the first surface of the board and the third surface of the terminal portion may face each other.

In connection with operation 705, the metal pad and the terminal portion may be connected through laser or ultrasonic welding. In this case, by allowing the laser beams or ultrasonic waves to pass through a recess (e.g., the recess 330c of FIGS. 9 to 11D) formed in the board, welding may be performed from the front direction (e.g., a direction opposite to the Z axis of FIGS. 9 to 11D) of the metal pad.

As described above, according to an embodiment of the disclosure, the degree of freedom of antenna design may be enhanced as the size of the terminal portion of the housing is reduced. For example, when the connecting member 340 is provided, and the board 330 and the terminal portion 319 are connected through the connecting member 340, the tip portion of the connecting member 340 may have to be brought into contact with the central portion of the metal pad 400. In this case, reducing the size of the metal pad 400 may be limited considering the dimensions and/or position of the connecting member 340, the assembly tolerance, the tolerance for the contact, and other design and/or manufacturing tolerances. Alternatively, according to the disclosure, by directly connecting the terminal portion to the board, it is not necessary to consider the tolerances for the connecting member 340, and thus the size of the metal pad may be further reduced. Accordingly, the size of the terminal portion may also be further reduced.

Further, as the terminal portion is reduced in size, the degree of design freedom of electronic components disposed around the terminal portion may be enhanced. For example, more advantages may be obtained in increasing the volume of the sound module disposed around the terminal portion or securing EMI performance according to being spaced apart from the camera module. Further, according to the disclosure, as the connecting member 340 is omitted, the conductive portion of the housing may be brought in tight contact with the board, allowing it possible to develop electronic devices which are more compact and lighter as reduced in size by the height of the connecting member 340. Further, it is possible to increase the price competitiveness of products by reducing the number of components.

Further, according to the disclosure, since the conductive portion of the housing and the board are assembled to be in tight contact to each other, and the housing and the board are firmly fixed through laser or ultrasonic welding, it is also expected to enhance impact resistance capable of resisting impact caused by falling.

Further, according to the disclosure, the metal pad may be soldered to the board, and the attachment deviation between the metal pad and the connecting member 340 may be greatly reduced, thereby preventing and/or reducing process defects.

Effects of the disclosure are not limited to the foregoing, and other unmentioned effects would be apparent to one of ordinary skill in the art from the following description.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used herein, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an example embodiment of the disclosure, there may be provided an electronic device comprising: a housing 210 including a conductive portion 318a, a board 330(e.g., printed circuit board) disposed inside the housing, and a metal pad 400 or 500 electrically connecting the board 330 and the conductive portion 318a and including a first surface at least partially facing the board and fixed to the board by soldering and a second surface at least partially facing the conductive portion and fixed to the conductive portion by laser welding or ultrasonic welding.

According to an example embodiment, the conductive portion 318a may further include a terminal protruding from the conductive portion 318a to an inside of the housing.

According to an example embodiment, the board 330 may further include a configured to transmit a laser beam and/or an ultrasonic wave.

According to an example embodiment, a center of the metal pad and a center of the recess may be aligned with each other.

According to an example embodiment, the metal pad may be fixed to the board by a plurality of solder portions radially arranged around the recess330c.

According to an example embodiment, a transparent member and/or translucent member comprising a translucent material may be disposed in the recess and configure to transmit the laser beam and/or the ultrasonic wave.

According to an example embodiment, the metal pad and the conductive portion may include a contact point formed by laser welding or ultrasonic welding.

According to an example embodiment, the contact point may include a plurality of contact points.

According to an example embodiment, the conductive portion may be configured to operate as an antenna radiator.

According to an example embodiment, a non-conductive portion 318b is disposed adjacent to the conductive portion.

According to an example embodiment, the conductive portion may be at least partially surrounded by the non-conductive portion.

According to an example embodiment, the recess includes an opening penetrating between a first surface 330a of the board and a second surface 330b of the board.

According to an example embodiment, the recess includes a hole or a groove configured to pass laser beams and/or ultrasonic waves therethrough.

According to an example embodiment of the disclosure, there may be provided a method of manufacturing an electronic device comprising: attaching a metal pad to a first surface (e.g., rear surface) of a board by soldering, positioning the metal pad on a surface (e.g., front surface) of a terminal portion, and welding the metal pad to the terminal portion using a laser beam or an ultrasonic wave provided from a direction parallel to a direction which the first surface faces.

According to an example embodiment, welding the metal pad to the terminal portion may be implemented by configuring a laser beam or an ultrasonic wave to pass through a recess formed in the board.

According to an example embodiment of the disclosure, there may be provided an electronic device comprising: a housing 210 including a front plate, a rear plate facing away from the front plate, and a side bezel structure 318 surrounding a space between the front plate and the rear plate, wherein the side bezel structure 318 includes a conductive portion 318a disposed adjacent to an inner space of the housing, a board 330(e.g., printed circuit board) disposed the inner space of the housing and including a recess 330c, and a metal pad electrically connecting the board 330 and the conductive portion 318a and including a first surface at least partially facing the board and fixed by soldering to the board and a second surface at least partially facing the conductive portion and fixed to the conductive portion by laser welding or ultrasonic welding. The metal pad and the conductive portion include at least one contact point formed by laser welding or ultrasonic welding

According to an example embodiment, the metal pad may be fixed to the board by a plurality of soldering portions radially arranged around the recess.

According to an example embodiment, a transparent member and/or translucent member comprising a translucent material may be disposed in the recess and configured to transmit the laser beam and/or the ultrasonic wave.

According to an example embodiment, the metal pad and the conductive portion may include a contact formed by laser or ultrasonic welding.

According to an example embodiment, the contact may be formed in a central portion of the metal pad.

According to an example embodiment, the contact may include a plurality of contacts.

According to an example embodiment, the conductive portion may be configured to operate as an antenna radiator.

According to an example embodiment, the conductive portion may be at least partially surrounded by a non-conductive portion.

According to an example embodiment, wherein the recess includes an opening, a hole or a groove configured to pass laser beams and/or ultrasonic waves therethrough.

While the disclosure has been illustrated and described with reference to various example embodiments, it will be understood that the various embodiments are intended to be illustrative, not limiting. It will be further understood by those skilled in the art that various changes, modifications, and/or alterations may be made thereto without departing from the true spirit and full scope of the disclosure, including the appended claims and their equivalents. It will also be understood that any of the embodiment(s) described herein may be used in conjunction with any other embodiment(s) described herein.

## Claims

1. An electronic device (101) comprising:
a housing (210) including a conductive portion (318a);
a board (330) disposed inside the housing; and
a metal pad (400, 500) electrically connecting the board (330) and the conductive portion (318a) and including a first surface at least partially facing the board and fixed to the board by soldering and a second surface at least partially facing the conductive portion and fixed to the conductive portion by laser welding or ultrasonic welding.

2. The electronic device of claim 1, wherein the conductive portion (318a) further includes a terminal portion (319) protruding from the conductive portion (318a) to an inside of the housing.

3. The electronic device of claim 1 or 2, wherein the board (330) further includes a recess for transmitting a laser beam or an ultrasonic wave.

4. The electronic device of claim 3, wherein a center of the metal pad and a center of the recess (330c) are aligned with each other.

5. The electronic device of claim 3, wherein the metal pad is fixed to the board by a plurality of solder portions radially arranged around the recess (330c).

6. The electronic device of claim 5, wherein a transparent member and/or translucent member comprising a translucent material is disposed in the recess (330c)and configured to transmit the laser beam and/or the ultrasonic wave.

7. The electronic device of any one of claims 1 to 5, wherein the metal pad and the conductive portion include a contact point formed by laser welding or ultrasonic welding.

8. The electronic device of claim 7, wherein the contact point includes a plurality of contact points.

9. The electronic device of any one of claims 1 to 8, wherein the conductive portion is configured to operate as an antenna radiator.

10. The electronic device of any one of claims 1 to 9, wherein a non-conductive portion (318b) is disposed adjacent to the conductive portion.

11. The electronic device of claim 10, wherein the conductive portion is at least partially surrounded by the non-conductive portion.

12. The electronic device of claim 1 to 11, wherein a recess is an opening penetrating between a first surface of the board and a second surface of the board.

13. The electronic device of any one of claims 1 to 11, wherein a recess includes a hole or a groove configured to pass laser beams or ultrasonic waves therethrough.

14. A method of manufacturing an electronic device, the method comprising:
attaching a metal pad to a first surface of a board by soldering;
positioning the metal pad on a surface of a terminal portion; and
welding the metal pad to the terminal portion using a laser beam or an ultrasonic wave provided from a direction parallel to a direction which the first surface faces.

15. The method of claim 14, wherein welding the metal pad to the terminal portion is implemented by configuring a laser beam or an ultrasonic wave to pass through a recess formed in the board.
